Europäisches Patentamt

European Patent Office

Office européen des brevets

(19)

(11) EP 0 895 286 A2

(12) **EUROPÄISCHE PATENTANMELDUNG**

(43) Veröffentlichungstag:
03.02.1999 Patentblatt 1999/05

(51) Int Cl.⁶: **H01L 23/48**, H01L 23/051

(21) Anmeldenummer: 98810668.8

(22) Anmeldetag: 13.07.1998

(84) Benannte Vertragsstaaten:
AT BE CH CY DE DK ES FI FR GB GR IE IT LI LU MC NL PT SE
Benannte Erstreckungsstaaten:
AL LT LV MK RO SI

(30) Priorität: 30.07.1997 DE 19732738

(71) Anmelder: Asea Brown Boveri AG
5401 Baden (CH)

(72) Erfinder:
• Klaka, Sven, Dr.
5415 Nussbaumen (CH)
• Voboril, Jan
5415 Nussbaumen (CH)

(74) Vertreter: Lück, Gert, Dr. et al
Asea Brown Boveri AG
Immaterialgüterrecht(TEI)
Haselstrasse 16/699 I
5401 Baden (CH)

(54) **Leistungshalbleiterbauelemente mit druckausgleichender Kontaktplatte**

(57) Die vorliegende Erfindung offenbart ein Leistungshalbleiterbauelement 1 mit einer speziellen Druckkontaktierung, das z. B. für Leistungsschalter, Gleichrichter, o. ä. in Industrieantrieben geeignet ist. Ein Druckausgleichselement 9 in Form einer Dose 10, 15 mit einem fliessfähigen oder plastisch deformierbaren Medium 12 wird zwischen einem Druckstempel 7a und einem Leistungshalbleiter 2 eingefügt. Aufgrund des hydrostatischen Drucks in der Dose 10 wird ein von einer Seite abgegebener inhomogener Druck auf der anderen Seite als homogener Druck weitergegeben. Eine homogene Druckabgabe auch im Randbereich der Druckflächen 11a, 11b kann durch eine Wölbung der Mantelfläche 13 nach innen erreicht werden. Vorzugsweise besteht die Dose 10, 15 aus Kupfer oder AlSiC und das Medium 12 aus einem flüssigen Metall (Ga, Hg), einem plastischen Metall (Pb, Al) oder aus Metallkügelchen (Cu) in Silikonöl. Die Dose kann ein- oder beidseitig eines oder mehrerer Leistungshalbleiter 2 angeordnet sein und auch die Molybdänscheiben 3a, 3b oder Kontaktplatten 4a, 4b ersetzen.

FIG. 4

EP 0 895 286 A2

**Beschreibung**

TECHNISCHES GEBIET

Die vorliegende Erfindung bezieht sich auf das Gebiet der Leistungselektronik. Sie geht aus von einem Leistungshalbleiterbauelement mit Druckkontaktstempeln nach dem Oberbegriff des Anspruchs 1.

STAND DER TECHNIK

Leistungshalbleiter für Industrie-, Traktions- und andere Anwendungen enthalten häufig Leistungshalbleiterbauelemente, wie z. B. Thyristoren, GTOs (gate turn - off thyristors), MCTs (MOS - controlled thyristors), Leistungsdioden, IGBTs (insulated gate bipolar transistors) oder MOSFETS (MOS - controlled field effect transistors), die in einem Gehäuse mit Druckkontakten gekapselt sind. Solche Druckgehäuse können z. B. einen grossflächigen Thyristor oder mehrere kleinflächige MOS - gesteuerte Halbleiterchips enthalten.

Ein derartiges Leistungshalbleiterbauelement ist z. B. aus dem U. S. Pat. No. 4,500,907 bekannt. Der typische Aufbau umfasst eine Halbleiterscheibe mit metallisierten Leistungskontakten, beidseitig anliegende Kontaktplatten und zwei zylindrische Metallstempel, durch welche die Anordnung in einem Gehäuse zusammengehalten wird. Die Kontaktplatten bestehen aus Molybdän (Mo) oder Wolfram (W) mit einem an Silizium angepassten Ausdehnungskoeffizienten. Die Metallstempel dienen der elektrischen und thermischen Druckkontaktierung des Leistungshalbleiters und der Wärmeabfuhr an eine Wärmesenke. Die erforderlichen hohen Anpressdrücke führen zu dem bekannten Problem, dass schädliche Drucküberhöhungen in der Halbleiterscheibe am Rande ihrer Berührungsfläche mit der starren Kontaktplatte auftreten können. Als Lösung wird vorgeschlagen, am Umfang der Metallstempel eine z. B. rechteckige, V - förmige oder bogenförmige Nut einzufräsen, um bei homogener Druckbelastung von aussen eine randseitige Druckentlastung durch elastische Deformation der Nut zu erzielen.

In dem U. S. Pat. No. 5,539,220 wird ein flaches Druckgehäuse für mehrere, nebeneinander angeordnete Halbleiterelemente vorgeschlagen, bei dem die Kontaktierung und Wärmeableitung durch Anpressen grossflächiger gemeinsamer Elektrodenplatten erfolgt. Ein solches Druckkontaktgehäuse wird bevorzugt mit mehreren IGBT - Chips und einer Freilaufdiode bestückt. Vorteile dieses Aufbaus betreffen die Verbesserung der Wärmedissipation sowie die Eliminierung der Bondierungsdrähte und ihrer Induktivitäten. Als Massnahmen zur Gewährleistung eines homogenen Anpressdrucks über alle Bauteile werden thermoplastische oder Lötschichten zwischen den Elektrodenplatten und Halbleitern und eine Angleichung der Bauhöhe von IGBTs und Freilaufdioden offenbart.

In beiden Schriften bleiben weitergehende Probleme aufgrund von Inhomogenitäten des von aussen auf die Bauelemente aufgeprägten Anpressdrucks ungelöst. Dies betrifft in erster Linie Unebenheiten von Kontaktplatten und ungleichmässig wirkende Klemmvorrichtungen. Sind eine Kontaktplatte oder eine Klemmvorrichtung verformt oder deformieren sie sich im Laufe der Zeit durch Lastwechsel, Materialermüdung o. ä., resultiert eine ungleichförmige Verteilung des Anpressdrucks über einzelne oder mehrere Leistungshalbleiterflächen. Das kann zu lokaler Überhitzung und zum Ausfall eines Halbleiterelementes führen. Bei GTOs z. B. ist die im Betrieb erworbene Verformung der Kontaktplatten und Metallstempel eine der häufigen Ausfallursachen. So können 10 mm dicke Kontaktplatten aus Kupfer Unebenheiten von 100 μm oder mehr aufweisen. Leichte Deformationen der Kontaktplatten treten jedoch schon bei deren Prüfung vor dem Einbau auf.

DARSTELLUNG DER ERFINDUNG

Aufgabe der vorliegenden Erfindung ist es, ein Leistungshalbleiterbauelement mit einer speziellen Druckkontaktierung anzugeben, durch welche die Homogenität der Druckverteilung über die Fläche der Leistungshalbleiter deutlich verbessert ist. Diese Aufgabe wird erfindungsgemäss durch die Merkmale des Anspruchs 1 gelöst.

Kern der Erfindung ist es nämlich, in ein druckkontaktiertes Leistungshalbleiterbauelement ein Druckausgleichselement einzufügen, welches ein fliessfähiges oder plastisch deformierbares Medium enthält, durch welches ein von einer Seite abgegebener inhomogener Druck auf der anderen Seite als homogener Druck weitergegeben wird.

Ein Ausführungsbeispiel zeigt ein Leistungshalbleiterbauelement mit einem einseitig angeordneten Druckausgleichselement in Form einer Dose, die mit einem flüssigen oder plastischen Metall oder mit Metallkugeln gefüllt ist.

In einem weiteren Ausführungsbeispiel wird ein Druckausgleichselement in Form einer Dose mit einer nach innen gewölbten, bogenförmigen Mantelfläche angegeben, welches sich durch eine auch in der Randzone gleichförmige Druckverteilung auszeichnet.

Ein anderes Ausführungsbeispiel zeigt eine einseitig offen Dose oder Wanne, in der ein weiches plastisches Metall gefangen ist.

Andere Ausführungsbeispiele, die u. a. mögliche Ausgestaltungen und Anordnungen der druckausgleichenden Dose sowie die Wahl des Befüllungsmediums betreffen, ergeben sich aus den abhängigen Ansprüchen.

Ein Vorteil des erfindungsgemässen Leistungshalbleiterbauelements besteht im verbesserten Schutz der Leistungshalbleiter vor mechanischer oder thermischer Schädigung aufgrund inhomogener Druckbelastungen.

Ein weiterer Vorteil besteht darin, dass sowohl statische als auch veränderliche inhomogene Druckverteilungen auf passive Weise zumindest weitgehend kompensierbar sind.

Ferner ist ein Vorteil auch darin zu erkennen, dass mit erfindungsgemässen Druckausgleichselementen eine Anordnung mehrerer Leistungshalbleiter nebeneinander oder übereinander in einem gemeinsamen Druckkontaktgehäuse auf einfache, zuverlässige und schonende Weise möglich ist.

## KURZE BESCHREIBUNG DER ZEICHNUNG

Die Erfindung wird nachstehend anhand von Ausführungsbeispielen erläutert. Es zeigen:

Fig. 1    einen Ausschnitt eines druckkontaktierten Leistungshalbleiterbauelements (Stand der Technik);

Fig. 2    einen Schnitt durch ein erfindungsgemässes Druckausgleichselement;

Fig. 3    einen Schnitt durch einen Randbereich des Druckausgleichselementes gemäss Fig. 2 mit einer nach innen gebogenen, kreisförmigen Mantelfläche;

Fig. 4    einen Schnitt durch ein Leistungshalbleiterbauelement mit einem einseitig angeordneten, erfindungsgemässen Druckausgleichselement;

Fig. 5    alternative Gestaltungen der Mantelfläche des Druckausgleichselements gemäss Fig. 2.

Fig. 6    einen Schnitt durch eine Variante des erfindungsgemässen Druckausgleichselements gemäss Fig. 2.

In den Figuren sind gleiche Teile mit gleichen Bezugszeichen versehen.

## WEGE ZUR AUSFÜHRUNG DER ERFINDUNG

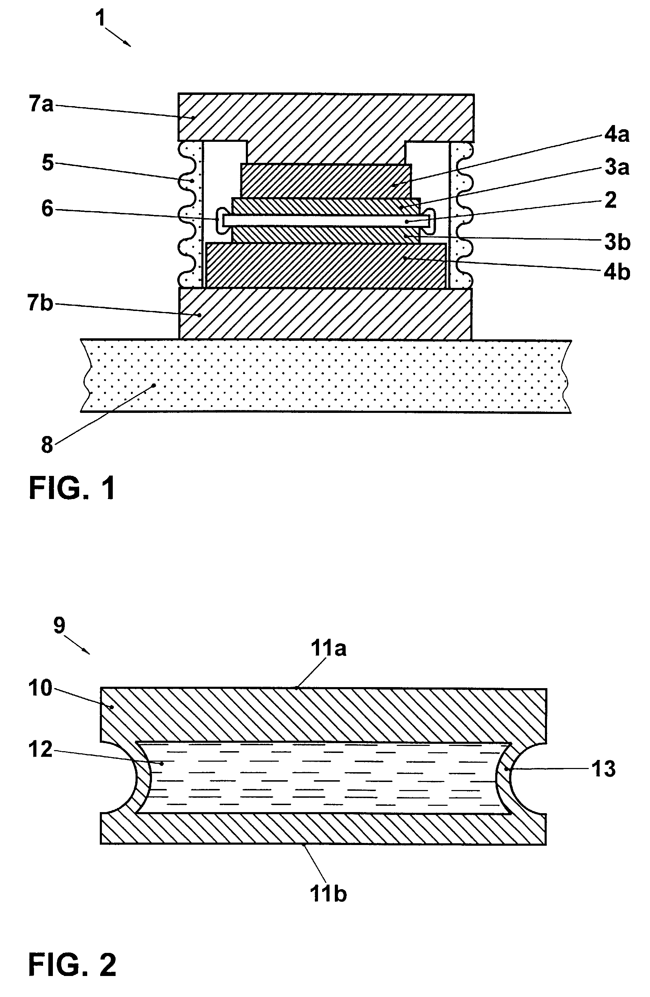

Fig. 1 zeigt ausschnittsweise ein bekanntes Leistungshalbleiterbauelement 1 mit mindestens einem Leistungshalbleiter 2 und einer beidseitigen Anordnung von Druckkontaktelementen 3a, 3b, 4a, 4b, insbesondere Molybdänscheiben 3a, 3b und Kontaktplatten 4a, 4b, sowie Druckstempeln 7a, 7b aus Kupfer. Der Leistungshalbleiter 2 ist am Rand durch einen Kautschukring 6 dielektrisch geschützt und zusammen mit den Molybdänscheiben 3a, 3b und Kontaktplatten 4a, 4b in einem gerippten Keramikisolator 5 untergebracht. Für eine gute elektrische und thermische Druckkontaktierung werden die Stempel 7a, 7b unter einem sehr hohen Anpressdruck von ca. 100 bar beispielsweise durch nicht dargestellte Tellerfedern gegeneinandergedrückt. Bereits kleine Unebenheiten der Molybdänscheiben 3a, 3b oder der Kontaktplatten 4a, 4b können dazu führen, dass die Halbleiterscheibe 2 durch lokale Druckspitzen mechanisch oder durch lokale Druckentlastungen und daraus resultierende Widerstandserhöhung thermisch geschädigt wird. Bei Lastzyklen ist das Bauelement 1 ferner Temperaturschwankungen von 100 °C und mehr ausgesetzt. Dies kann durch thermische Ausdehnung, Materialermüdung, Materialverzug, Bimetalleffekte, usw. eine Inhomogenität der von aussen aufgeprägten Druckverteilung verursachen, die bis zum Leistungshalbleiter 2 weitergegeben wird, soweit sie nicht durch flexible Durchbiegung dazwischenliegender Elemente (3a, 3b, 4a, 4b, 7a, 7b) ausgeglichen wird. Beim herkömmlichen Aufbau sind diese Elemente jedoch relativ starr. Sind mehrere Leistungshalbleiter 2 übereinandergestapelt oder nebeneinander auf einer Trägerplatte 8 angeordnet und in einem gemeinsamen Druckkontaktgehäuse über zwei oder mehr Druckstempel 7a, 7b kontaktiert, so können sich derartige Druckinhomogenitäten akkumulieren und die Verwendbarkeit eines Druckkontaktgehäuses einschränken oder gänzlich verunmöglichen.

Es ist Gegenstand der Erfindung, eine druckausgleichende Kontaktplatte bzw. ein druckausgleichendes Druckkontaktelement bzw. Druckausgleichselement 9 anzugeben, welches den von einer Seite abgegebenen inhomogenen Druck auf der anderen Seite als gleichmässigen Druck weitergibt. Es ist auch wünschenswert, dass das Druckausgleichselement 9 mechanische Deformationen kompensieren kann. Darüberhinaus soll das Druckausgleichselement 9 eine gute elektrische und insbesondere thermische Leitfähigkeit aufweisen, um zur Leitung hoher Ströme im kA - Bereich und möglichst zur Abführung von Verlustwärme im kW - Bereich geeignet zu sein.

Eine bevorzugte Ausführungsform ist in Fig. 2 dargestellt. Eine Dose 10 mit einer oberen und unteren Druckfläche 11a, 11b ist innen mit einem fliessfähigen oder plastisch deformierbaren Medium 12 gefüllt. Die Dose kann beispielsweise aus Kupfer bestehen und (Hg) oder Blei (Pb) enthalten. Wird nun beispielsweise die obere Druckfläche 11a mit ungleichförmigem Druck beansprucht, so baut sich im Doseninneren ein hydrostatischer Druck auf, der zusammen mit der über die Mantelfläche 13 geleiteten Kraft die erforderliche Gegenkraft bildet. Der hydrostatische Druck wird wegen der Viskosität oder Plastizität des Mediums 12 gleichverteilt auf die untere Druckfläche 11b übertragen. Deshalb kann nur noch die Mantelfläche 13 als Quelle für Inhomogenitäten der Druckverteilung auf der unteren Fläche 11b wirken. Ist die Seitenwand 13 starr und zudem senkrecht orientiert, wird sie unmittelbar den oben randseitig anliegenden Druck, insbesondere den über die Mantelfläche 13 abgestützten Teil der elastischen Rückstellkraft der Druckfläche 11a, auf den unteren Randstreifen 14 weitergeben. Umgekehrt wird eine elastische oder völlig flexible Wand nur wenig oder gar keinen Druck auf den unteren Randstreifen 14 übertragen. Vorteilhafterweise sind die Elastizität der Druckplatten 11a, 11b und der Mantelfläche 13 sowie die Kompressibilität des Mediums 12 so aufeinander abgestimmt, dass die Einfederung der Dose 10 bei den erforderlichen hohen Drücken kleiner als 1 mm, vorzugsweise kleiner als 0.2 mm, beträgt und die Kraft hauptsächlich über das Medium 12 übertragen wird. Es ist daher sinnvoll, ein inkompressibles oder nur wenig kompressibles Befüllungsmedium 12 zu wählen.

Mechanische Deformationen können insbesondere lokal durch Unebenheiten der Druckkontaktelemente 3a, 3b, 4a, 4b, insbesondere der Molybdänscheiben 3a, 3b und Kontaktplatten 4a, 4b, oder der Druckstempel 7a, 7b oder global durch eine ungleichmässig wirkende Klemmvorrichtung hervorgerufen werden. Die lokalen Deformationen werden hauptsächlich durch die Elastizität der Druckflächen 11a, 11b aufgefangen und die globalen Deformationen hauptsächlich durch eine keilförmige Schrägstellung der Druckflächen aufgrund der Elastizität der Seitenwand 13. Das Medium 12 wird in beiden Fällen ausweichen und/oder komprimiert werden. Typischerweise sind Deformationen in der Grössenordnung des Einfederungsweges gut kompensierbar.

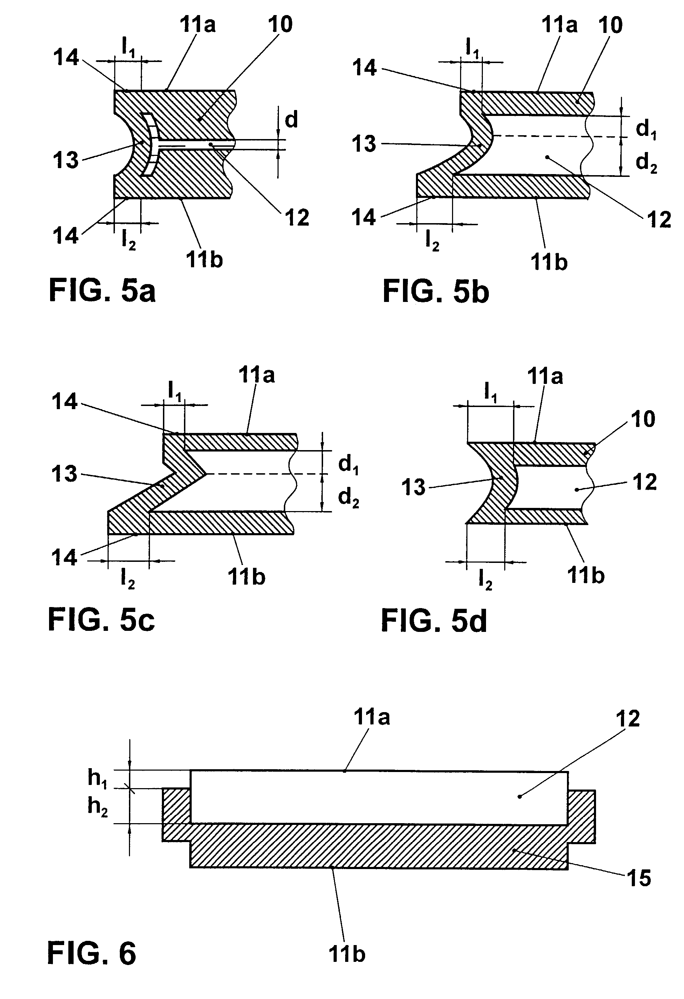

Die Dose 10 soll alleine oder zusammen mit dem Medium 12 eine hinreichende elektrische und insbesondere thermische Leitfähigkeit des Druckausgleichselementes 9 gewährleisten. Deshalb muss die Dose 10 zumindest einen elektrisch leitfähigen Deckel 11a oder Boden 11b aufweisen. Sie kann vollständig oder teilweise aus einem Metall, z. B. Kupfer, oder einer metallischen Keramik bestehen. Insbesondere kann sie einen Deckel 11a oder Boden 11b oder eine Wanne 15 (s. Fig. 6) aus einem Material mit einem an den Leistungshalbleiter 2 angepassten thermischen Ausdehnungskoeffizienten umfassen, wie z. B. Molybdän, Wolfram oder AlSiC.

Als Befüllungsmedium kommen neben Hg und Pb insbesondere Gallium (Ga), Zinn (Sn), Aluminium (Al), Indium (In), eine Metalllegierung oder ein anderes flüssiges oder plastisch deformierbares Metall oder eine Mischung in Frage. Alternativ oder ergänzend dazu kann auch eine Mischfüllung von Metallkugeln, z. B. aus Kupfer mit einigen 0.1 mm Durchmesser, in einer wärmeleitenden Flüssigkeit oder Paste, z. B. Silikonöl oder Silikonvaseline vorgesehen sein. Eine solche Mischfüllung ist hinreichend fliessfähig und erfüllt die Aufgabe der Druckverteilung restlos. Bei einer dichtesten Anordnung der Kugeln ergäbe sich ein Füllfaktor von ca. 70%, was einen hinreichend niedrigen Wärmewiderstand bewirkt. Die elektrische Stromleitung kann zum Teil oder weitgehend über die Mantelfläche 13 erfolgen. Die Mischfüllung ist besonders für einen weiten Temperaturbereich, z. B. von -40 °C bis 150 °C, gut geeignet.

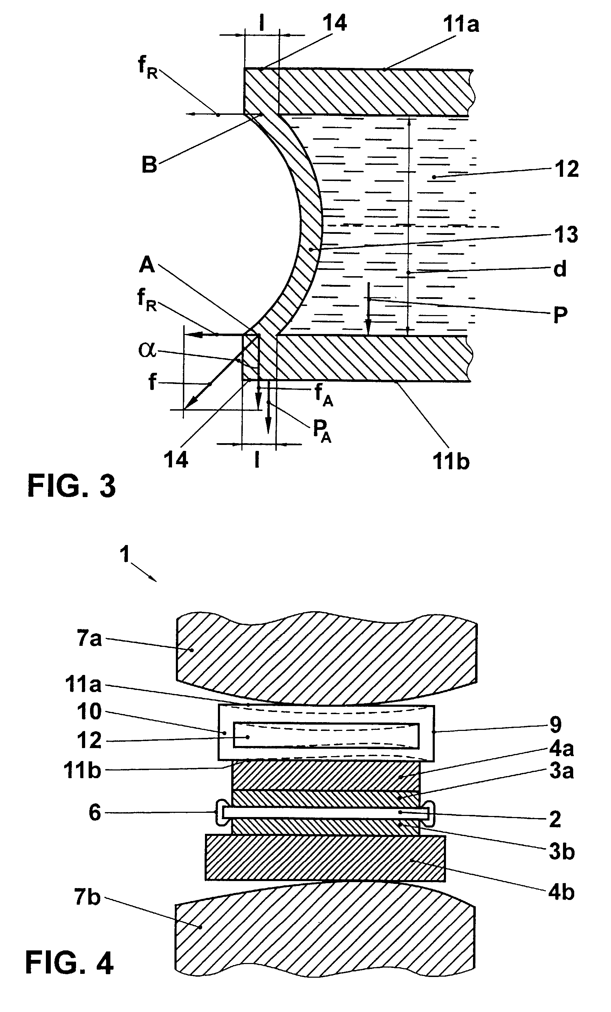

Eine homogene Druckabgabe über die gesamte untere Druckfläche 11b kann nun durch eine geschickte Formgebung und Dimensionierung des Randbereichs 13, 14 erzielt werden. Ein bevorzugtes Ausführungsbeispiel mit einer kreisbogenförmig nach innen gewölbten, bezüglich der gestrichelten Mittellinie symmetrischen Mantelfläche 13 ist in Fig. 3 zu sehen. Die Kraftübertragung über die Seitenwand 13 sei vernachlässigbar. Der hydrostatische Druck p bewirkt entlang der Innenhöhe d eine radial nach aussen gerichtete Kraft auf die Mantelfläche 13, die in den Auflagepunkten A und B des Kreisbogens je zur Hälfte abgestützt wird. Die im Kreisbogen wirkende Kraft f pro Längeneinheit des Zylinderumfangs ist jedoch unter dem Winkel $\alpha$, unter dem die Mantelfläche mit den Druckflächen 11a, 11b zusammentrifft, tangential gerichtet und besitzt deshalb neben der Radialkomponente fR auch eine Vertikalkomponente bzw. Auflagekraft pro Länge $f_A$. Es ist ein Ziel der Erfindung, $f_A$ so zu dimensionieren, dass der resultierende Druck $p_A$ auf einen Randstreifen 14 der Breite l dem hydrostatischen Druck p gleicht. Aus den Gleichungen

$$f_R = f \cdot \sin (\alpha) = p \cdot d / 2 \qquad (1)$$

und

$$f_A = f \cdot \cos (\alpha) = p_A \cdot 1 \qquad (2)$$

findet man für eine Innenhöhe d und einen Winkel $\alpha$ eine Randstreifenbreite

$$1 = d / (2 \cdot \tan (\alpha)). \qquad (3)$$

Der Winkel a wird vorteilhafterweise im Bereich zwischen 30° und 60°, insbesondere gleich 45°, gewählt. Die resultierende Wölbung der Mantelfläche 13 ist dann einerseits gross genug, um auch mit geringen Wandstärken eine gute Stabilität zu erzielen und aufgrund der Flexibilität eine Randbelastung von oben abzufedern, und andererseits klein genug, um für die gewünschte Auflagekraft $f_A$ die Tangentialkraft f in Grenzen zu halten.

Als Beispiel sei eine typische Dimensionierung einer druckausgleichenden Dose 10 angegeben: Durchmesser = 100 mm, Gesamthöhe = 10 mm, $\alpha$ = 45°, Wandstärke der oberen bzw. unteren Druckflächen 11a, 11b = 3 mm bzw. 2 mm. Dann beträgt die Innenhöhe d = 5 mm und die Randstreifenbreite l = 2,5 mm.

In Fig. 4 ist die Wirkungsweise eines Druckausgleichselementes 9 gemäss Fig. 3 in einem Leistungshalbleiterbauelement 1 gemäss Fig. 1 dargestellt. Ist z. B. der obere Druckstempel 7a konvex gekrümmt, wird die obere Druckfläche 11a sehr ungleichmässig, im Extremfall sogar nur punktuell, belastet und ein Druck im Medium 12 erzeugt, der sich im Rahmen der Fliessfähigkeit bzw. seitlichen Verschiebbarkeit des Mediums 12 allseitig homogen ausbreitet und gleichverteilt auf die untere Druckfläche 11b überträgt. Von unten wirkende inhomogene Druckverteilungen können in analoger Weise durch ein zweites, nicht dargestelltes, beispielsweise zwischen dem Druckstempel 7b und der Kontaktplatte 4b angeordnetes Druckausgleichselement 9 abgefangen werden. Die Druckelemente 9 können auch an anderen Stellen eingefügt werden, insbesondere zwischen einer Kontaktplatte 4a, 4b und einer Molybdänscheibe 3a, 3b oder anstelle einer Kontaktplatte 4a, 4b. Ein besonders einfacher Aufbau resultiert, wenn die an der Halbleiterscheibe 2 anliegende Druckfläche 11a, 11b des Druckausgleichselementes 9 als Molybdänscheibe 3a, 3b ausgebildet ist. Dann erübrigen sich separate Molybdänscheiben 3a, 3b. Die Druckausgleichselemente 9 können auch die Kontaktplatten 4a, 4b oder alle Druckkontaktelemente 3a, 3b, 4a, 4b ersetzen. Vorteilhafterweise wird das zweite Druckausgleichselement 9 dünner als das erste gewählt, um seinen Wärmewiderstand niedriger zu halten und eine gute Kühlung des Leistungshalbleiters 2 sicherzustellen.

Wie in Fig. 4 dargestellt kann jedoch bereits ein einziges, einseitig z. B. oben angeordnetes Druckausgleichselement 9 eine von unten wirkende ungleichförmige Druckverteilung homogenisieren. Ist beispielsweise der untere Druckstempel 7b konvex gekrümmt, können die Halbleiterscheibe 2 und die Druckkontaktelemente 3a, 3b, 4a, 4b, insbesondere die Molybdänscheiben 3a, 3b und Kontaktplatten 4a, 4b, die Krümmung mitmachen und auf das Druckausgleichselement 9 übertragen. Eine Voraussetzung dafür ist eine gute Flexibilität aller Elemente 4b, 3b, 2, 3a, 4a. Durch eine Wahl hinreichend dünner Molybdänscheiben 3a, 3b und Kontaktplatten 4a, 4b ist diese Anforderung erfüllbar, da die Halbleiterscheibe 2 i.a. sehr flexibel ist. Darüberhinaus muss in diesem Fall auch die untere Druckfläche 11b flexibel deformierbar ausgelegt sein, um wie zuvor gezeigt die mechanische Deformation abzubauen. Dafür werden der Boden 11b des Druckausgleichselements 9 hinreichend dünnwandig sowie die Seitenwand 13 hinreichend flexibel und/oder das Befüllungsmedium 12 hinreichend kompressibel gewählt. In diesem Fall wird also eine beidseitige inhomogene Druckbelastung durch ein einseitig angeordnetes Druckausgleichselement 9 mit zumindest einer elastisch deformierbaren Druckfläche 11a oder 11b in eine homogene Druckverteilung über die Halbleiterscheibe 2 umgewandelt. Zudem besteht hier der Vorteil, dass keine oder deutlich verringerte Anforderungen an die Wämeleitfähigkeit des Druckausgleichselementes 9 gestellt werden, weil die Wärmeableitung über die andere Seite des Leistungshalbleiterbauelementes 1 erfolgen kann.

Fig. 5a - 5d zeigen alternative Ausgestaltungen der Mantelfläche des Druckausgleichselementes 9. Ein Ausführungsbeispiel nach Fig. 5a zeichnet sich durch einen dickwandigen Boden und Deckel und geringe Innenhöhe d von typischerweise < 1 mm aus. Der zu befüllende, schlitzförmige Innenraum erstreckt sich zwischen den Druckflächen 11a, 11b und entlang der Mantelfläche 13, um eine homogene Druckbelastung der Seitenwand 13 und damit die bei Fig. 3 diskutierte gleichförmige Druckverteilung auf dem Randstreifen 14 sicherzustellen. Ein Vorteil dieser Anordnung besteht im verringerten Wärmewiderstand aufgrund der reduzierten Dicke des Mediums 12.

Fig. 5b zeigt ein Ausführungsbeispiel mit einer unsymmetrischen, bogenförmigen Mantelfläche 13 und unterschiedlich grossen Druckflächen 11a und 11b. Auch hier ist es wünschenswert, gleichförmige Druckverteilungen über die gesamten Druckflächen 11a und 11b zu erzielen. Analog zur Herleitung von Gleichung (3) führen die erfindungsgemässen Überlegungen zu zwei unabhängigen Bedingungen für die Breiten $l_1$ und $l_2$ der oberen und unteren Randstreifen 14. Für gegebene Winkel $\alpha_1$ und $\alpha_2$, unter denen die Mantelfläche 13 mit der oberen und unteren Druckfläche 11a, 11b zusammentrifft, und gegebene Innenhöhen $d_1$ und $d_2$, die von einer Taille der Dose 10 bis zum Deckel 11a und Boden 11b gemessen sind, soll die Dose 10 Randstreifen 14 der Breiten

$$l_1 = d_1 / \tan(\alpha_1) \text{ und} \qquad (4)$$

$$l_2 = d_2 / \tan(\alpha_2) \qquad (5)$$

aufweisen. Die gesamte Innenhöhe ist $d = d_1 + d_2$. Die Gleichungen (4) und (5) gelten gleichermassen auch für eine V - förmige Mantelfläche 13. Wie zuvor ist es günstig, wenn die Winkel im Bereich $30° < \alpha_1, \alpha_2 < 60°$ liegen und vorzugsweise $\alpha_1 = \alpha_2 = 45°$ betragen. Insbesondere ist durch eine Winkelwahl $\alpha_1 \neq \alpha_2$ oder Wahl der Innenhöhen $d_1 \neq d_2$ eine Vergrösserung oder Verkleinerung der Druckflächen 11a, 11b relativ zueinander unter Beibehaltung einer homogenen Druckbelastung erzielbar, was aus konstruktiven Gründen günstig sein kann.

Die Fig. 5c und 5d zeigen schliesslich weitere Ausführungsbeispiele mit V - förmig nach innen gewölbter Mantelfläche 13 oder scharfen Aussenkanten. Auch andere Formen der Mantelfläche 13, insbesondere eine wie in Fig. 2 dargestellte zylindrische, sind denkbar. Vorteilhafterweise besitzt die Dose 10 eine rotationssymmetrische Mantelfläche 13, die insbesondere kreisförmig, bogenförmig, V - förmig oder anderweitig nach innen gewölbt ist.

Eine weitere Variante des erfindungsgemässen Druckausgleichselementes 9 ist in Fig. 6 dargestellt. Ein relativ weiches, plastisch deformierbares Medium 12 ist in einer offenen Dose bzw. Wanne 15 aus einem harten Material teilweise oder vollständig gefangen. Das weiche Medium 12 bildet die obere Druckfläche 11a und der Boden der Wanne 15 die untere Druckfläche 11b. Die Wanne 15 kann zusätzlich noch andere, u. U. härtere Medien 12 enthalten. Für eine ganzflächig homogene Druckverteilung ist es günstig, wenn das weiche Medium 12 über den Rand der Wanne 15 übersteht. Die überstehende Höhe $h_1$ des Mediums 12 soll dabei kleiner als die Wannentiefe h2 gewählt werden, um ein seitliches Ausweichen des Mediums 12 unter Druck weitgehend zu verhindern. Das weiche Medium 12 passt sich den Druckinhomogenitäten durch plastische Verformung an und ermöglicht so über die gesamte Druckfläche 11a einen Druckausgleich. Das Material für die offene Dose 15 muss sich durch grosse Härte und gute elektrische Leitfähigkeit auszeichnen. Wünschenswert sind auch eine gute Wärmeleitfähigkeit und geringe, an den Leistungshalbleiter 2 angepasste thermische Ausdehnungskoeffizienten. Besonders geeignet sind AlSiC, Molybdän oder Wolfram. Als Medium 12 kommen ein oder mehrere der zuvor genannten plastischen Materialien, insbesondere Aluminium, aber auch Kupfer in Frage.

Die genannten Ausführungsbeispiele können auf vielfältige Weise verallgemeinert werden.

Die Bestückung des Druckkontaktgehäuses umfasst mindestens einen Leistungshalbleiter 2, wie z. B. Thyristor, GTO, MCT, Leistungsdiode, IGBT oder MOSFET, kann aber auch andere Beschaltungskomponenten beinhalten. Eine Anzahl der Leistungshalbleiter 2 wird je nach der geforderten Schaltleistung gewählt. Insbesondere können mehrere Leistungshalbleiter 2 übereinandergestapelt und/oder nebeneinander angeordnet sein. Die Anordnung nebeneinander ist besonders für eine Parallelschaltung mehrerer IGBTs von Interesse, da diese bisher nur mit relativ kleinen aktiv steuerbaren Flächen herstellbar sind. Dabei kann ein Leistungshalbleiterbauelement 1 ein oder mehrere Druckausgleichselemente 9 bzw. Dosen 10, 15 enthalten, die einseitig oder beidseitig von einem oder mehreren Leistungshalbleitern 2 angeordnet sind. Insbesondere kann je ein Druckausgleichselement 9 beidseitig von übereinandergestapelten und/oder nebeneinander angeordneten Leistungshalbleitern 2 angeordnet sein.

Die Form der Dose 10, 15 kann beliebig variiert werden, sofern sie zwei Druckflächen 11a, 11b zur Aufnahme und Weitergabe des Drucks von einem Druckstempel 7a, 7b an mindestens einen Leistungshalbleiter 2 aufweist. Bevorzugt sind die Druckflächen 11a, 11b eben und zueinander parallel.

Die Druckstempel 7a, 7b sollen mit einer Wärmesenke thermisch in Kontakt stehen. Günstigerweise sind sie selber als Kühlkörper ausgelegt, wobei sie z. B. mit Rippen zur Luftkühlung oder mit einer eingefrästen Spirale zur Flüssigkeitskühlung ausgestattet sind.

Neben den eingangs erwähnten Vorteilen weist ein erfindungsgemässes Druckausgleichselement 9 insbesondere folgende Vorzüge auf. Es werden sowohl intrinsische, lokale als auch von aussen aufgeprägte, globale Druckinhomogenitäten abgebaut. Dadurch können die mechanischen Toleranzen des gesamten Leistungshalbleiterbauelements 1 grosszügiger bemessen und die Ausfallrate gesenkt werden.

In herkömmlichen Leistungshalbleiterbauelementen 1 lässt die Anpresskraft nach Überdruckbelastungen oder durch Materialermüdung nach. Dieses Problem ist aufgrund der Elastizität des Druckausgleichselementes 9 weitgehend zurückgedrängt.

Das Druckausgleichselement 9 kann zusätzlich die Funktion der heutzutage verwendeten Druckkontaktelemente 3a, 3b, 4a, 4b, insbesondere der Molybdänscheiben 3a, 3b und Kontaktplatten 4a, 4b, übernehmen. Dann lassen sich die herkömmlichen Druckkontaktelemente (3a, 3b, 4a, 4b) einzeln oder gemeinsam durch Druckausgleichselemente 9 ersetzen. Dabei bleiben die bekannten Vorteile einer flexiblen Druckkontaktierung, insbesondere ein einfacher Aufbau, eine einfache Ersetzbarkeit von Bauteilen oder Bestückungselementen und eine sehr hohe thermische Belastbarkeit gewahrt.

Insgesamt kann durch die Erfindung der Anwendungsbereich von Druckkontaktgehäusen zur elektrischen und auch thermischen Kontaktierung von Leistungshalbleitern 2 erweitert und die Zuverlässigkeit und Sicherheit solcher Leistungshalbleiterbauelemente 1 erhöht werden.

**BEZUGSZEICHENLISTE**

| | |
|---|---|
| 1 | Leistungshalbleiterbauelement |
| 2 | Leistungshalbleiter |
| 3a, 3b, 4a, 4b | Druckkontaktelemente |
| 3a, 3b | Molybdänscheiben |
| 4a, 4b | Kontaktplatten |
| 5 | Keramikisolator |
| 6 | Kautschukring |
| 7a, 7b | Druckstempel |
| 8 | Trägerplatte |
| 9 | Druckausgleichselement |
| 10 | Dose |
| 11a | Boden |
| 11b | Deckel |
| 11a, 11b | Druckflächen |

| | |
|---|---|
| 12 | Medium |
| 13 | Mantelfläche, Seitenwand |
| 14 | Randstreifen |
| 15 | Wanne |
| A, B | Auflagepunkte |
| $\alpha$ | Winkel |
| p | hydrostatischer Druck |
| f | Tangentialkaft pro Längeneinheit des Zylinderumfangs |
| $f_R$ | Radialkraft pro Längeneinheit des Zylinderumfangs |
| $f_A$ | Auflagekraft pro Längeneinheit des Zylinderumfangs |
| $h_1$ | überstehende Höhe |
| $h_2$ | Wannentiefe |

**Patentansprüche**

1. Leistungshalbleiterbauelement (1) mit mindestens einem Leistungshalbleiter (2) und Druckstempeln (7a, 7b) zur Kontaktierung des Leistungshalbleiters (2), dadurch gekennzeichnet, dass

   a) zwischen dem Leistungshalbleiter (2) und den Druckstempeln (7a, 7b) mindestens ein elektrisch leitfähiges Druckausgleichselement (9) angeordnet ist,
   b) das Druckausgleichselement (9) eine Dose (10, 15) umfasst, die mit einem fliessfähigen oder plastisch deformierbaren Medium (12) gefüllt ist.

2. Leistungshalbleiterbauelement (1) nach Anspruch 1, dadurch gekennzeichnet, dass

   a) das Medium (12) inkompressibel oder wenig kompressibel ist und
   b) das Medium (12) elektrisch und thermisch leitfähig ist.

3. Leistungshalbleiterbauelement (1) nach einem der Ansprüche 1 oder 2, dadurch gekennzeichnet, dass

   a) die Dose (10, 15) eine obere und untere Druckfläche (11a, 11b) und eine rotationssymmetrische oder zylindrische Mantelfläche (13) besitzt,
   b) die Druckflächen (11a, 11b) eben und zueinander parallel sind und
   c) die Dose (10, 15) elektrisch leitfähig ist.

4. Leistungshalbleiterbauelement (1) nach Anspruch 3, dadurch gekennzeichnet, dass

   a) das Medium (12) ein flüssiges oder plastisches Metall oder Metallkugeln in einer wärmeleitenden Flüssigkeit oder Paste umfasst,
   b) die Dose (10, 15) teilweise oder vollständig aus Metall oder einer metallischen Keramik besteht und
   c) die Dose (10, 15) einen Deckel (11a) oder Boden (11b) oder eine Wanne (15) aus einem thermisch leitfähigen Material mit einem an den Leistungshalbleiter (2) angepassten thermischen Ausdehnungskoeffizienten aufweist.

5. Leistungshalbleiterbauelement (1) nach einem der Ansprüche 3 oder 4, dadurch gekennzeichnet, dass

   a) die Mantelfläche (13) kreisförmig, bogenförmig oder V - förmig nach innen gewölbt ist,
   b) die Mantelfläche (13) mit der oberen und unteren Druckfläche (11a, 11b) unter dem Winkel $\alpha_1$ und $\alpha_2$ zusammentrifft,
   c) die Dose (10) von einer Taille bis zum Deckel (11a) und Boden (11b) gemessene Innenhöhen $d_1$ und d2 aufweist,
   d) die Dose (10) obere und untere Randstreifen (14) der Breiten

   $$l_1 = d_1 / \tan (\alpha_1)$$

   und

   $$l_2 = d_2 / \tan (\alpha_2)$$

   aufweist und
   e) insbesondere die Winkel $\alpha_1$ und $\alpha_2$ im Bereich 30° < $\alpha_1$, $\alpha_2$ < 60° liegen und vorzugsweise $\alpha_1 = \alpha_2 = 45°$ betragen.

6. Leistungshalbleiterbauelement (1) nach Anspruch 5, dadurch gekennzeichnet, dass die Dose (10) einen schlitzförmigen Innenraum aufweist, der sich zwischen den Druckflächen (11a, 11b) und entlang der Mantelfläche (13) erstreckt.

7. Leistungshalbleiterbauelement (1) nach einem der Ansprüche 1 - 4, dadurch gekennzeichnet, dass

   a) die Dose (15) eine Wanne (15) aus einem harten Material umfasst,

b) in der Wanne (15) ein weiches, plastisch deformierbares Medium (12) gefangen ist und
c) das weiche Medium (12) die obere Druckfläche (11a) bildet.

**8.** Leistungshalbleiterbauelement (1) nach einem der Ansprüche 1 - 7, dadurch gekennzeichnet, dass

a) der mindestens eine Leistungshalbleiter (2) vom Typus Thyristor, GTO, MCT, Leistungsdiode, IGBT oder MOSFET ist,
b) die Dose (10) einen Deckel (11a) oder Boden (11b) oder eine Wanne (15) aus einem Material aufweist, welches der Gruppe AlSiC, Molybdän oder Wolfram entstammt und
c) das Medium (12) aus der Gruppe Quecksilber, Blei, Gallium, Zinn, Aluminium, Indium, Kupfer stammt und/oder Kugeln aus Kupfer in Silikonöl oder Silikonvaseline enthält.

**9.** Leistungshalbleiterbauelement (1) nach einem der Ansprüche 1 - 8, dadurch gekennzeichnet, dass mehrere Druckausgleichselemente (9) einseitig oder beidseitig von einem oder mehreren Leistungshalbleitern (2) angeordnet sind.

**10.** Leistungshalbleiterbauelement (1) nach einem der Ansprüche 4 - 9, dadurch gekennzeichnet, dass

a) je ein Druckausgleichselement (9) beidseitig von übereinandergestapelten und/oder nebeneinander angeordneten Leistungshalbleitern (2) angeordnet ist und
b) die Druckausgleichselemente (9) die Druckkontaktelemente (3a, 3b, 4a, 4b) ersetzen.

**11.** Druckkontaktgehäuse, geeignet für ein Leistungshalbleiterbauelement (1) nach dem Oberbegriff des Anspruchs 1, mit einem Druckkontaktelement (3a, 3b, 4a, 4b), dadurch gekennzeichnet, dass mindestens ein Druckkontaktelement (3a, 3b, 4a, 4b) eine Dose (10, 15) ist, die mit einem fliessfähigen oder plastisch deformierbaren Medium (12) gefüllt ist.

**12.** Druckkontaktelement (3a, 3b, 4a, 4b), geeignet für ein Druckkontaktgehäuse eines Leistungshalbleiterbauelementes (1) nach dem Oberbegriff des Anspruchs 1, dadurch gekennzeichnet, dass das Druckkontaktelement (3a, 3b, 4a, 4b) eine Dose (10, 15) ist, die mit einem fliessfähigen oder plastisch deformierbaren Medium (12) gefüllt ist.

1

7a

4a

5

3a

6

2

3b

4b

7b

8

**FIG. 1**

9

11a

10

12

13

11b

**FIG. 2**

**FIG. 3**

**FIG. 4**

FIG. 5a

FIG. 5b

FIG. 5c

FIG. 5d

FIG. 6

11